# EUROPEAN PATENT APPLICATION

(11) **EP 4 618 116 A1**
(43) Date of publication of application: **17.09.2025**
(21) Application number: 24163332.0
(22) Date of filing: 13.03.2024
(51) Int. Cl.: H01F 27/02

(54) **A CONTAINER, SUCH AS A TANK, FOR AN ELECTRICAL DEVICE SUCH AS A TRANSFORMER, CONNECTED TO AN ELECTRICAL PULSE GENERATING UNIT**

(71) Applicant: Nodica Group AB, 754 54 Uppsala (SE)
(72) Inventor: TYRSING, Oliver, 754 54 UPPSALA (SE)
(74) Representative: AWA Sweden AB

(57) **Abstract**

A container (60) is disclosed. The container (60) is configured to accommodate an electrical device (20) connected or connectable to an electrical pulse generating unit (10), the electrical pulse generating unit (1) being configured to generate one or more electrical pulses to be conveyed to the electrical device (20). The container (60) comprises an enclosing structure (61) having an inner surface (64) at least in part delimiting an interior space (70) of the container, in which interior space the electrical device is arranged or arrangeable. The enclosing structure (61) has an electrical feedthrough arrangement (80) comprised in a portion (65) of the enclosing structure (61).

## Description

### TECHNICAL FIELD

The present invention generally relates to the field of electrical equipment. Specifically, the present invention relates to a container, such as a tank, configured to accommodate an electrical device, such as a transformer, connected or connectable to an electrical pulse generating unit.

### BACKGROUND

Electrical pulses may be employed in a variety of applications, such as, for example, radar systems, particle accelerators, sterilization equipment, high-energy lasers, microwave systems, or medical devices. In such and other applications it may be desired or required to deliver one or more electrical pulses to a load.

An electrical energy storage unit or module such as a capacitor may be used to store electrical energy, which when discharged generates an electrical pulse that can be delivered to the load, or to a pulse transformer. The capacitor may be repeatedly charged by a power supply unit or power supply arrangement connected to a power source. The capacitor may repeatedly or cyclically be charged and discharged in order to generate a plurality of successive electrical pulses. Arrangements, apparatuses, systems or circuits which are employed for generating electrical pulses may be referred to as power modulators, or pulse modulators. A power modulator may be used to deliver electrical pulses of high power to a specialized load, such as indicated in the foregoing.

A power modulator, or pulse modulator, may employ a pulse transformer in order to obtain the required or desired voltage of the electrical pulses. A pulse transformer may comprise a core. Further, a pulse transformer may comprise one or more so-called primary windings and one or more so-called secondary windings. The pulse transformer may be used for transferring electrical pulse energy from the pulse transformer's primary side (i.e., the `side' of the transformer having the one or more first windings) to the pulse transformer's secondary side (i.e., the `side' of the transformer having the one or more secondary windings), normally with a change in voltage and current. The core is normally made of some magnetic material, and the primary and secondary windings may be made of copper (e.g., copper wires) or some other suitable material. In operation, the pulse transformer is often positioned in a container, or housing, which might be referred to as a transformer tank. Within the container or housing (or transformer tank) there may be provided a suitable fluid such as an oil (e.g., a mineral-based or silicone-based insulating oil) by which any component within the container or housing may be cooled, and which fluid may also provide electrical insulation. At least one, some, or each of the component(s) within the container or housing, such as the pulse transformer, may be immersed or submerged in such fluid.

### SUMMARY

An apparatus such as a power modulator or pulse modulator may comprise an electrical pulse generating unit, which may be configured to generate one or more electrical pulses to be conveyed to a load, e.g., a load of a type as indicated in the foregoing. The electrical pulse generating unit may comprise an electrical energy storage unit. The electrical pulse generating unit may comprise a power supply, which may be configured to selectively charge the electrical energy storage unit of the electrical pulse generating unit. The electrical pulse generating unit may be configured to generate one or more electrical pulses by charging (partially or completely) and discharging (partially or completely) of the electrical energy storage unit of the electrical pulse generating unit, wherein when the electrical energy storage unit of the electrical pulse generating unit is discharged, an electrical pulse may be created to be conveyed to the load. In many applications, it may be desired or even required that the voltage of any electrical pulses which may be generated by the electrical pulse generating unit is relatively high, e.g., tens of kV or even hundreds of kV (e.g., up to (e.g., about) 400 kV or even more).

The electrical pulse generating apparatus may comprise a transformer, which may be referred to as a pulse transformer such as described in the foregoing. The transformer may be arranged such that any electrical pulse generated by the electrical pulse generating unit is conveyed to the load via the transformer. The transformer may comprise one or more primary windings, to which the electrical pulse generating unit is connected or connectable, and one or more secondary windings, to which the load is connected or connectable. As mentioned in the foregoing, in operation, a pulse transformer is often positioned in a container, or housing, which might be referred to as (and constitute or be included in) a transformer tank. Thus, the said transformer may be arranged or arrangeable within an interior space of the container or housing. As it may generally be desired or even required for the transformer to be immersed or submerged in a fluid such as an oil for purposes of cooling and electrical insulation, the interior space of the container or housing may be sealed from the surroundings of the container or housing. Therefore, in order to connect the transformer with the electrical pulse generating unit (and/or to connect the transformer with the load), an electrical feedthrough arrangement for the container or housing may be needed, by which electrically conducting path(s) between the transformer while being positioned in the container or housing and the electrical pulse generating unit may be achieved. The electrically conducting path(s) may allow or facilitate for any electrical pulse generated by the electrical pulse generating unit to be conveyed to the transformer.

Such an electrical feedthrough arrangement might be considered as an interface between one or more first electrical conductors such as one or more cables to which the electrical pulse generating unit may be connected and one or more second electrical conductors such as one or more cables to which the transformer while being positioned in the container or housing may be connected. Thus, the electrical feedthrough arrangement may provide an interface for electrically connecting the one or more first electrical conductors with the one or more second electrical conductors. With reference to the example of the container or housing being constituted or including a transformer tank, the electrical feedthrough arrangement may be arranged in a wall of the transformer tank.

Conventional electrical feedthrough arrangements may require a relatively large number of constituent parts. With further reference to the example of the container or housing being a transformer tank, conventional electrical feedthrough arrangements may include, for example, one or more feedthrough electrical conductors arranged to at least in part extend through a wall of the transformer tank, one or more electrical contacts at the outside of the transformer tank for connecting the feedthrough electrical conductor(s) to the one or more first electrical conductors to which the electrical pulse generating unit may be connected, and one or more electrical contacts at the inside of the transformer tank for connecting the feedthrough electrical conductor(s) to the one or more second electrical conductors to which the transformer while being positioned in the container or housing may be connected. The requirement of a relatively large number of constituent parts of conventional electrical feedthrough arrangements may entail a relatively long tolerance chain, which may make it difficult to achieve a finished (e.g., assembled) part which meets the acceptable tolerance limits. Therefore, it would be desired to provide an electrical feedthrough arrangement which has a relatively short tolerance chain. These considerations may be applicable not only to electrical feedthrough arrangements for a container or housing configured to accommodate a transformer (e.g., a pulse transformer), but also to electrical feedthrough arrangements for a container or housing configured to accommodate another or other types of electrical devices.

In view of the above, a concern of the present invention is to provide a container or housing configured to accommodate an electrical device connected or connectable to an electrical pulse generating unit, which container or housing comprises an electrical feedthrough arrangement by which electrically conducting path(s) between the electrical device while being positioned in the container or housing and the electrical pulse generating unit may be achieved, which electrical feedthrough arrangement has a relatively short tolerance chain.

To address at least one of this concern and other concerns, a container in accordance with the independent claim is provided. Preferred embodiments are defined by the dependent claims.

According to a first aspect, a container is provided, which container is configured to accommodate an electrical device connected or connectable to an electrical pulse generating unit. The electrical pulse generating unit is configured to generate one or more electrical pulses to be conveyed to the electrical device. The container comprises an enclosing structure, which has an inner surface at least in part delimiting an interior space of the container, in which interior space the electrical device is arranged or arrangeable. The enclosing structure has an electrical feedthrough arrangement comprised in a portion of the enclosing structure. The electrical feedthrough arrangement comprises at least one first electrically conducting path, configured to conduct current in a direction from the electrical pulse generating unit to the electrical device, and at least one second electrically conducting path, configured to conduct current in a direction from the electrical device to the electrical pulse generating unit. At least a portion of the said portion of the enclosing structure is electrically conductive. Each first electrically conducting path may have a corresponding second electrically conducting path. Each first electrically conducting path and the corresponding second electrically conducting path may be configured to form a part of a corresponding closed electrical circuit between the electrical pulse generating unit and the electrical device. Each first electrically conducting path is at least in part formed by at least one electrical conductor surrounded by an electrically insulating body fitted within a corresponding through-hole in the said portion of the enclosing structure extending between an outer surface of the enclosing structure and the inner surface of the enclosing structure. Each second electrically conducting path is at least in part formed by an electrically conductive portion of the said portion of the enclosing structure.

By the at least one first electrically conducting path and the at least one second electrically conducting path, electrically conducting paths between the electrical device while being arranged in the interior space of the container and the electrical pulse generating unit may be achieved. By the at least a portion of the said portion of the enclosing structure being electrically conductive and by each second electrically conducting path of the electrical feedthrough arrangement being at least in part formed by an electrically conductive portion of the said portion of the enclosing structure, this or these electrically conducting paths may be in part realized by way of a portion of the enclosing structure (e.g., by being directed in or extending through the material of the said portion of the enclosing structure). By employing a portion of the enclosing structure in such a way, it may be possible to keep the number of constituent parts of the electrical feedthrough arrangement in accordance with the first aspect relatively low as compared to conventional electrical feedthrough arrangements, whereby the electrical feedthrough arrangement in accordance with the first aspect may have relatively short tolerance chain.

As mentioned, the first electrically conducting path(s) is or are not realized by way of a portion of the enclosing structure. Rather, the first electrically conducting path(s) is or are at least in part formed by at least one electrical conductor surrounded by an electrically insulating body fitted within a corresponding through-hole in the said portion of the enclosing structure extending between an outer surface of the enclosing structure and the inner surface of the enclosing structure. Such a configuration of the first electrically conducting path(s) may be preferable to realizing the first electrically conducting path(s) by way of a portion of the enclosing structure, which is the case for the second electrically conducting path(s). This is due to that a configuration of the first electrically conducting path(s) with it or them being at least in part formed by at least one electrical conductor surrounded by an electrically insulating body fitted within a corresponding through-hole in the said portion of the enclosing structure extending between an outer surface of the enclosing structure and the inner surface of the enclosing structure may be better suited to handle the (e.g., full) pulse energy of any electrical pulse(s) generated by the electrical pulse generating unit and subsequently conveyed to the electrical device via the first electrically conducting path(s). The magnitude of current in a direction from the electrical device to the electrical pulse generating unit may be (e.g., much) lower compared to the magnitude of current in a direction from the electrical pulse generating unit to the electrical device (which may be about 1200 A or even higher in some applications) due to the pulse energy of any electrical pulse(s) generated by the electrical pulse generating unit having been transferred into a load which may be connected or connectable with the electrical pulse generating unit via the electrical device (which may comprise, e.g., a pulse transformer), and the realization of the second electrically conducting path(s) by way of a portion of the enclosing structure may be sufficient for handling such lower magnitude currents. A configuration of the first electrically conducting path(s) such as described above may be particularly advantageous in applications where the current of any electrical pulses which may be generated by the electrical pulse generating unit is relatively high, e.g., corresponding to a voltage of tens of kV or even hundreds of kV (e.g., up to (e.g., about) 400 kV or even more), and/or where any electrical pulses which may be generated by the electrical pulse generating unit are relatively fast, e.g., having a duration of just above 0 s to (e.g., about) 25 µs, e.g., from (e.g., about) 0.5 µs to (e.g., about) 25 µs, and/or have relatively fast rise time and fall time (e.g., about 1 µs or less). However, it is contemplated that the first electrically conducting path(s) could in principle, at least in some applications, be realized by way of a portion of the enclosing structure, just as the second electrically conducting path(s).

As another alternative, it is contemplated that in principle, in some applications each first electrically conducting path could be at least in part formed by an electrically conductive portion of the said portion of the enclosing structure, and each second electrically conducting path could be at least in part formed by at least one electrical conductor surrounded by an electrically insulating body fitted within a corresponding through-hole in the said portion of the enclosing structure extending between an outer surface of the enclosing structure and the inner surface of the enclosing structure.

As indicated in the foregoing, the electrical device, which may be accommodated in the container or housing, and which may be connected or connectable to an electrical pulse generating unit, may for example comprise a transformer, or several transformers. The electrical pulse generating apparatus may be connected or connectable to a load, and the electrical pulse generating apparatus may be configured to generate one or more electrical pulses to be conveyed to the load, wherein the transformer(s) may be arranged such that any electrical pulse generated by the electrical pulse generating unit is conveyed to the load via the transformer. As such, the transformer(s) may be referred to a pulse transformer(s). The load may for example comprise or be constituted by one or more of a microwave amplifier, a klystron, a magnetron, or a particle emitter, such as, for example, an electron emitter (which may be referred to as an electron gun).

The at least one first electrically conducting path may be configured to convey the one or more electrical pulses generated by the electrical pulse generating unit to the electrical device. The at least one second electrically conducting path may constitute a current return path from the electrical device and may be connected to ground. Thus, the said portion of the enclosing structure may be used as a ground connection. Therefore, according to one or more embodiments of the present invention, the at least one second electrically conducting path may be considered as ground return path from the electrical device. The at least one second electrically conducting path of the electrical feedthrough arrangement may be directed or extending through the said portion of the enclosing structure.

The enclosing structure may comprise at least one wall, at least one opening, and at least one closure device, which may be connected to the at least one wall or formed by a portion of the at least one wall. The at least one closure device may be configured to selectively close or open the at least one opening. The interior space may be delimited at least in part by an inner surface of the at least one wall. The said portion of the enclosing structure may comprise a portion of the at least one wall. In alternative or in addition, the said portion of the enclosing structure may comprise the at least one closure device.

The container may be constituted by or include a tank (e.g., a transformer tank). Thus, according to one or more embodiments of the present invention, a wall of the tank may be used as a ground connection and/or the at least one second electrically conducting path of the electrical feedthrough arrangement may be directed through a portion of the wall of the tank.

The at least one closure device may comprise a lid or cover. The said portion of the enclosing structure may comprise a portion of the lid or cover. With further reference to the example of the container being constituted or including a tank, the lid or cover of the tank may hence be used as a ground connection and/or the at least one second electrically conducting path of the electrical feedthrough arrangement may be directed or extending through a portion of the lid or cover of the tank. By a portion of the lid or cover of the tank (and/or a wall thereof) being used to realize or implement the at least one second electrically conducting path of the electrical feedthrough arrangement, it may be possible to keep the number of constituent parts of the electrical feedthrough arrangement relatively low compared to conventional electrical feedthrough arrangements, whereby the electrical feedthrough arrangement may have relatively short tolerance chain.

The enclosing structure may have a bottom part. The interior space of the container may be delimited at least in part by an inner surface of the wall(s) of the enclosing structure and possibly by an inner surface of any bottom part. At least a part or portion of the enclosing structure (e.g., any wall(s) and/or any bottom part) may for example be made in stainless steel, and may comprise pieces of stainless less which have been welded together. At least a part or portion of the enclosing structure, e.g., another part or portion of the enclosing structure (e.g., at least one closure device such as a lid or cover) may be made in aluminum and/or another similar material. Possibly, the entire or substantially the entire enclosing structure may be made in aluminum and/or another similar material, and may have been made using a process such as casting.

Particularly with reference to the example of the container being constituted or including a tank, the enclosing structure of the container may be configured to seal (e.g., fluidly seal) the interior space from the surroundings of the container.

Each first electrically conducting path may be further formed by a first electrical contact and a second electrical contact. Each of the first electrical contact and the second electrical contact may be made of a metallic material. The first electrical contact may be fixedly attached to the at least one electrical conductor at a first end thereof, which may be arranged at an outer surface of the said portion of the enclosing structure. The second electrical contact may be fixedly attached to the at least one electrical conductor at a second end thereof, which may be arranged at an inner surface of the said portion of the enclosing structure. The first electrical contact and the second electrical contact may be coupled (e.g., electrically and possibly mechanically) via the at least one electrical conductor.

As mentioned, each first electrically conducting path is at least in part formed by at least one electrical conductor surrounded by an electrically insulating body fitted within a corresponding through-hole in the said portion of the enclosing structure extending between an outer surface of the enclosing structure and the inner surface of the enclosing structure. The at least one electrical conductor may for example comprise or be constituted by a body made of electrically conductive material, such as, for example, copper, aluminum, and/or brass, which body may have a (e.g., generally) cylindrical shape. The electrically insulating body may for example comprise or be constituted by a body made of electrically insulating material, such as, for example, one or more plastics. The electrically insulating body may have a (e.g., generally) cylindrical shape with an interior space (e.g., being defined by a through-hole in the electrically insulating body, which through-hole may extend along a longitudinal direction of the electrically insulating body) into which the at least one electrical conductor may be fitted (e.g., interference fitted or press fitted). The electrically insulating body may for example be made by means of injection molding. The electrically insulating body may for example be or generally be configured as a screw, and may have outer threads facilitating or allowing for the electrically insulating body to be fitted within the corresponding through-hole in the said portion of the enclosing structure. The outer threads may match with grooves or threads on a surface of the said portion of the enclosing structure which defines the corresponding through-hole in the said portion of the enclosing structure, such that the electrically insulating body may be screwed into the said portion of the enclosing structure.

For each first electrically conducting path, the electrically insulating body and/or the said portion of the enclosing structure may be arranged such that the electrically insulating body is sealingly fitted within the corresponding through-hole in the said portion of the enclosing structure. For example, for each first electrically conducting path, the electrically insulating body and the said portion of the enclosing structure may be arranged such that the electrically insulating body is threadingly connected to a surface of the said portion of the enclosing structure which defines the corresponding through-hole in the said portion of the enclosing structure. By such a threaded connection, or screw connection, the electrically insulating body may be sealingly fitted within the corresponding through-hole in the said portion of the enclosing structure. However, other configurations are possible for achieving such a sealingly fitting of the electrically insulating body within the corresponding through-hole in the said portion of the enclosing structure.

For each first electrically conducting path, the electrically insulating body may comprise a through-hole extending between an outer surface of the said portion of the enclosing structure and an inner surface of the said portion of the enclosing structure. The through-hole may extend along a longitudinal direction of the electrically insulating body. The at least one electrical conductor may be fitted within the through-hole of the electrically insulating body. The electrically insulating body and/or the at least one electrical conductor may be arranged such that the at least one electrical conductor is sealingly fitted within the through-hole of the electrically insulating body. For example, the electrically insulating body and the at least one electrical conductor may be arranged such that the at least one electrical conductor is threadingly connected to a surface of the electrically insulating body which defines the through-hole of the electrically insulating body.

Each second electrically conducting path may be further formed by a first electrical contact and a second electrical contact. Each of the first electrical contact and the second electrical contact may be made of a metallic material. The first electrical contact may be fixedly attached to an outer surface of the electrically conductive portion of the said portion of the enclosing structure. The second electrical contact may be fixedly attached to an inner surface of the electrically conductive portion of the said portion of the enclosing structure. The first electrical contact and the second electrical contact may be coupled (e.g., electrically and possibly mechanically) via the electrically conductive portion of the said portion of the enclosing structure.

For each first electrically conducting path and the corresponding second electrically conducting path, each of the first electrically conducting path and the corresponding second electrically conducting path may comprise an elongated electrical conductor (e.g., including a cable and/or a metal plate or strip) extending into the interior space and towards the electrical device when the electrical device is arranged in the interior space. At least a portion of the electrical conductors of the first electrically conducting path and the corresponding second electrically conducting path which extend into the interior space may extend parallel to each other (or substantially parallel to each other) and at a distance from each other that is in a range between 0.1 mm and 1 mm, preferably in a range between 0.1 mm and 0.5 mm. Possibly, the said distance could however be less than 0.1 mm. As mentioned, according to one or more embodiments of the present invention, the at least one second electrically conducting path may be considered as ground return path from the electrical device. In applications where the current of any electrical pulses which may be generated by the electrical pulse generating unit is relatively high, e.g., corresponding to a voltage of tens of kV or even hundreds of kV (e.g., up to (e.g., about) 400 kV or even more), and where any electrical pulses which may be generated by the electrical pulse generating unit are relatively fast, e.g., having a duration of just above 0 s to (e.g., about) 25 µs, e.g., from (e.g., about) 0.5 µs to (e.g., about) 25 µs, and also have relatively fast rise time and fall time (e.g., about 1 µs or less), there may be an unacceptable increase in impedance between each first electrically conducting path and the corresponding second electrically conducting path. In this regard, it can be noted that even if the electrical pulse generating unit and the electrical device can be considered to be part of a DC system, in applications as mentioned above with very fast, high current electrical pulses having relatively fast rise time and fall time, the electrical pulse generating unit and the electrical device may be represented as an AC system. By the (portions of the) electrical conductors of the first electrically conducting path and the corresponding second electrically conducting path being arranged at a relatively small distance from each other, e.g., in a range between 0.1 mm and 1 mm, it may be facilitated or allowed to keep the impedance between each first electrically conducting path and the corresponding second electrically conducting path relatively low (e.g., sufficiently low) even in applications with very fast, high current electrical pulses having relatively fast rise time and fall time such as described above.

An electrical pulse generating unit in a power modulator may employ a power supply and an electrical energy storage unit that can be charged or discharged. The electrical pulse generating unit to which the electrical device is connected or connectable to may comprise an electrical energy storage unit that can be charged or discharged. The electrical energy storage unit may for example comprise a capacitor or several capacitors (e.g., a capacitor bank). Electrical pulses may be generated by repeatedly or cyclically charging and discharging the electrical energy storage unit, wherein when the electrical energy storage unit is discharged, an electrical pulse is generated which may be conveyed to, and received by, the electrical device. As mentioned, the electrical device may comprise one or more transformers arranged such that any electrical pulse generated by the electrical pulse generating unit is conveyed to a load via the transformer(s). The electrical energy storage unit may be partially or completely charged and discharged. After the electrical energy storage unit has been discharged to generate an electrical pulse, the electrical energy storage unit should be charged again in preparation for any subsequent electrical pulse. In order to carry out the charging and discharging of the electrical energy storage unit, a switch or switching device may be included in the electrical pulse generating unit, which may selectively connect or disconnect a power supply with the electrical energy storage unit. The switch or switching device of an electrical pulse generating unit that is based on discharge of an electrical energy storage unit such as a capacitor may be referred to as a pulse switch or pulse switching device. Thus, the electrical pulse generating unit to which the electrical device is connected or connectable to may comprise a switch unit (or switch, or switch element), which may be controllably switchable between at least a conducting state and a non-conducting state (or substantially non-conducting state). The switch unit may be connected to the power supply and to the electrical energy storage unit of the electrical pulse generating unit, respectively, such that the power supply charges the electrical energy storage unit of the electrical pulse generating unit by way of a charging current supplied by the power supply, or the electrical energy storage unit of the electrical pulse generating unit is discharged so as to create an electrical pulse to be conveyed to the load, based on switching of the at least one switch unit between at least the conducting state and the (e.g., substantially) non-conducting state thereof. For example, the switch unit may be electrically connected to the power supply and the electrical energy storage unit of the electrical pulse generating unit, respectively, such that when the switch unit is switched into the non-conducting state, the power supply charges the electrical energy storage unit of the electrical pulse generating unit by way of a charging current supplied by the power supply, and when the switch unit is switched into the conducting state, the electrical energy storage unit of the electrical pulse generating unit is discharged so as to create an electrical pulse to be conveyed to the electrical device and possibly the load.

It is to be understood that while electrical energy storage unit(s) may be referred to herein as a capacitor, it is to be understood that more than one capacitor and/or another or other types of electrical energy storage units than capacitors may possibly be used, e.g., inductive electrical energy storage units. Thus, even if electrical energy storage unit(s) may be referred to herein as a capacitor, the disclosure herein is applicable in the same way or similarly for other types of electrical energy storage units than capacitors.

Thus, each or any of the electrical energy storage unit(s) of the electrical pulse generating unit may comprise or be constituted by one or more capacitors. In alternative or in addition, each or any of the electrical energy storage unit(s) of the electrical pulse generating unit may comprise or be constituted by another or other types of electrical energy storage units than capacitors, e.g., inductive electrical energy storage units.

The power supply may for example comprise a power converter. For example, the power supply may comprise or be connectable to an Alternating Current (AC) source, and may further comprise a rectifier for converting AC from the AC source into Direct Current (DC) which can be used to charge the electrical energy storage unit of the electrical pulse generating unit.

In the context of the present application, by a non-conducting state of the switch unit it is meant a state where there is no or only very little conduction of current through the switch unit. Thus, the switch unit may be switchable so as to stop, or substantially stop, the switch unit from conducting current through the switch unit.

In the context of the present application, by a switch unit it is meant an electrical device or element which is capable of switching (parts or portions of) electrical signals or electrical power, and which may also be capable of attenuating or blocking and/or amplifying electrical signals or electrical power. The switch unit could in alternative - in accordance with one or more embodiments of the present invention - be referred to as a switching transistor element. The switch unit may for example be a power semiconductor-based switch unit. The switch unit may comprise at least one transistor or transistor device and/or another or other types of (e.g., power) semiconductor devices. The switch unit may for example comprise one or more solid-state semiconductor switching devices with turn-on and turn-off capability, such as, for example, at least one Insulated-Gate Bipolar Transistor (IGBT), Integrated Gate-Commutated Transistor (IGCT), metal oxide semiconductor field effect transistor (MOSFET) and/or gate turn-off thyristor (GTO), but is not limited thereto. According to another example, the switch unit may for example comprise or be constituted by one or more field-effect transistors (FETs), for example MOSFETs and/or junction gate FETs (JFETs).

According to a second aspect, an electrical pulse generating apparatus is provided. The electrical pulse generating apparatus is connected or connectable to a load. The electrical pulse generating apparatus comprises an electrical pulse generating unit configured to generate one or more electrical pulses to be conveyed to the load. The electrical pulse generating apparatus comprises an electrical device constituted by a transformer connected or connectable to the electrical pulse generating unit and arranged such that any electrical pulse generated by the electrical pulse generating unit is conveyed to the load via the transformer. The electrical pulse generating apparatus comprises a container according to the first aspect configured to accommodate the transformer, wherein the transformer is arranged in the interior space of the container. The load may for example comprise or be constituted by one or more of a microwave amplifier, a klystron, a magnetron, or a particle emitter.

Further objects and advantages of the present invention are described in the following by means of exemplifying embodiments. It is noted that the present invention relates to all possible combinations of features recited in the claims. Further features of, and advantages with, the present invention will become apparent when studying the appended claims and the description herein. Those skilled in the art realize that different features of the present invention can be combined to create embodiments other than those described herein.

### BRIEF DESCRIPTION OF THE DRAWINGS

Exemplifying embodiments of the present invention will be described below with reference to the accompanying drawings.
Figure 1 is a schematic circuit diagram of an electrical pulse generating apparatus according to one or more embodiments of the present invention.
Figure 2 is a schematic perspective view of an electrical pulse generating apparatus according to one or more embodiments of the present invention, which electrical pulse generating apparatus is connected to a load.
Figure 3 is a schematic perspective view of a portion of the enclosing structure of a container according to one or more embodiments of the present invention, in which portion of the enclosing structure an electrical feedthrough arrangement according to one or more embodiments of the present invention is comprised in.
Figure 4 is an in-part sectional view of the portion of the enclosing structure illustrated in Figure 3.
Figure 5 is a more detailed view of the section of the portion of the enclosing structure illustrated in Figure 4.
Each of Figures 6 and 7 is a schematic view of a part of a first electrically conducting path of an electrical feedthrough arrangement of a container according to one or more embodiments of the present invention.

The figures are schematic, not necessarily to scale, and generally only show parts which are necessary in order to elucidate embodiments of the present invention, wherein other parts may be omitted or merely suggested.

### DETAILED DESCRIPTION

The present invention will now be described hereinafter with reference to the accompanying drawings, in which exemplifying embodiments of the present invention are shown. The present invention may, however, be embodied in many different forms and should not be construed as limited to the embodiments of the present invention set forth herein; rather, these embodiments are provided by way of example so that this disclosure will convey the scope of the present invention to those skilled in the art.

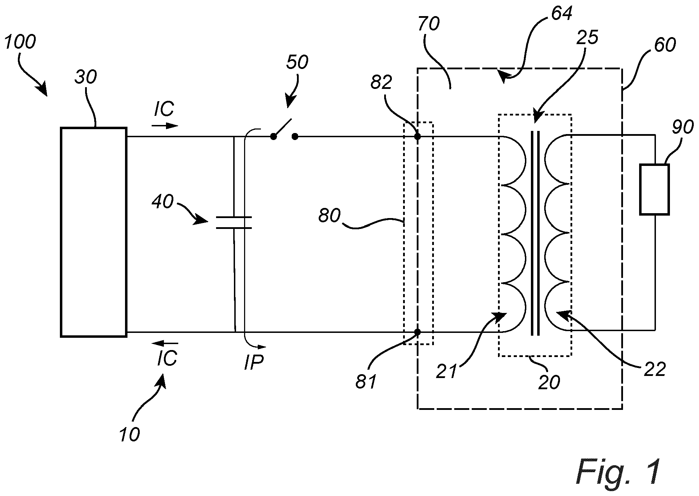

Figure 1 is a schematic view of an electrical pulse generating apparatus 100 according to an embodiment of the present invention. The electrical pulse generating apparatus 100 comprises an electrical pulse generating unit 10 that is connected (or connectable) to a load 90. The load 90 may for example comprise or be constituted by one or more of a microwave amplifier, a klystron, a magnetron, or a particle emitter, such as, for example, an electron emitter (which may be referred to as an electron gun).

The electrical pulse generating unit 10 is configured to generate one or more electrical pulses to be conveyed to the load 90. In accordance with the embodiment of the present invention illustrated in Figure 1, the electrical pulse generating unit 10 comprises an electrical energy storage unit 40, and a power supply 30, which is configured to selectively charge the electrical energy storage unit 40.

In accordance with the embodiment of the present invention illustrated in Figure 1, the electrical energy storage unit 40 comprises a capacitor. It is however to be understood that the electrical energy storage unit 40 could comprise several capacitors (e.g., a capacitor bank) and/or another or other types of electrical energy storage units than capacitors, e.g., inductive electrical energy storage units.

The power supply 30 may for example comprise a power converter. For example, the power supply may comprise or be connectable to an Alternating Current (AC) source (not shown in Figure 1) and may further comprise a rectifier (not shown in Figure 1) for converting AC from the AC source into Direct Current (DC) which can be used to charge the electrical energy storage unit 40. For example, the power supply 30 may be connectable or connected to a power source (not shown in Figure 1) that is supplying AC power, having one phase or a plurality of phases. The power source could for example be configured to supply three-phase AC power. The power source could for example comprise or be constituted by an electrical grid, which may supply three-phase AC power, e.g., mains electric power. The power supply 30 might comprise an input rectifier (not shown in Figure 1). The input rectifier may be is arranged to receive the AC power supplied by the power source when the power supply 30 is connected to the power source. The input rectifier may for example comprise or be constituted by a multi-phase rectifier, which may comprise a plurality of phase legs.

In accordance with the embodiment of the present invention illustrated in Figure 1, the electrical pulse generating unit 10 comprises a switch unit 50. The switch unit 50 may be configured such that the electrical conductivity of a current path through the switch unit 50 is controllable by transmission of a modulated (e.g., digital) drive signal to the switch unit 50. The switch unit 50 may be controllably switchable between different operational states thereof, for example by means of such a drive signal. The switch unit 50 may for example comprise one or more solid-state semiconductor switching devices with turn-on and turn-off capability, such as, for example, at least one Insulated-Gate Bipolar Transistor (IGBT), Integrated Gate-Commutated Transistor (IGCT), metal oxide semiconductor field effect transistor (MOSFET) and/or gate turn-off thyristor (GTO) but is not limited thereto. The switch unit 50 may for example comprise or be constituted by one or more IGBTs and/or MOSFETs (e.g., power MOSFETs).

The electrical pulse generating unit 10 is configured to generate one or more electrical pulses by charging and discharging of the electrical energy storage unit 40, wherein when the electrical energy storage unit 40 is discharged, at least a part of an electrical pulse is created to be conveyed to the load 90. The switch unit 50 is connected to the power supply 30 and to the electrical energy storage unit 40, respectively, such that the power supply 30 charges the electrical energy storage unit 40 by way of a charging current supplied by the power supply 30, or the electrical energy storage unit 40 is discharged so as to create an electrical pulse to be conveyed to the load 90, based on switching of the switch unit 50 between different operational states thereof.

In accordance with the embodiment of the present invention illustrated in Figure 1, the charging current that may be supplied by the power supply 30, based on switching of the switch unit 50 between different operational states thereof, may flow out of the power supply 30 via the conductor of the two conductors connected to the power supply 30 that is uppermost in Figure 1, and return to the power supply 30 via the conductor of the two conductors connected to the power supply 30 that is lowermost in Figure 1, as indicated by the arrows IC in Figure 1. The two above-mentioned conductors may for example be connected to two terminals of the power supply 30.

Further in accordance with the embodiment of the present invention illustrated in Figure 1, the current of an electrical pulse, which is generated when the electrical energy storage unit 40 is discharged, may for example flow in the direction indicated by the arrow IP in Figure 1. The electrical pulse generating unit 10 may for example be configured such that the duration of each or any electrical pulse that is generated is in a range from 0.5 µs to 25 µs, for example.

The electrical pulse generating apparatus 100 comprises an electrical device 20 which - according to the illustrated embodiment of the present invention - includes a transformer. The electrical device 20 may in the following be referred to as a transformer 20 without any loss of generality, and it is to be understood that the electrical device could in accordance with one or more embodiments of the present invention in alternative or in addition include one or more electrical devices of other type than a transformer.

The transformer 20 is arranged such that any electrical pulse generated by the electrical pulse generating unit 10 is conveyed to the load 90 via the transformer 20. The transformer 20 comprises one or more primary windings 21, to which the electrical pulse generating unit 10 is connected or connectable, and one or more secondary windings 22, to which the load 90 is connected or connectable. The primary winding(s) of the transformer 20 may be configured to receive the electrical pulse(s) generated by the electrical pulse generating unit 10.

In accordance with the embodiment of the present invention illustrated in Figure 1 and as indicated therein, the transformer 20 may comprise four primary windings 21. However, it is to be understood that the number of primary windings 21 of the transformer 20 is not limited to four, but may for example be larger than four, or less than four. Further in accordance with the embodiment of the present invention illustrated in Figure 1 and as indicated therein, the transformer 20 may comprise four secondary windings 22. However, it is to be understood that the number of secondary windings 22 of the transformer 20 is not limited to four, but may for example be larger than four, or less than four.

The transformer 20 may comprise at least one core 25.

For example, the transformer 20 may be connected to the electrical pulse generating unit 10 by way of two terminals thereof, as illustrated in Figure 1. And as further illustrated in Figure 1, the transformer may be connected to the load 90 via the secondary winding(s) 22 of the transformer 20.

The electrical pulse generating apparatus 100 comprises a container, schematically indicated at 60 in Figure 1, which container 60 is configured to accommodate the transformer 20. As illustrated in Figure 1 and as indicated in the foregoing, the transformer 20 is connected (or connectable) to the electrical pulse generating unit 10, and the transformer 20 is arranged such that any electrical pulse generated by the electrical pulse generating unit 10 is conveyed to the load 90 via the transformer 20. As such, the transformer 20 may be referred to a pulse transformer.

The container 60 may be constituted by or include a tank. As such, the container 60 could be referred to as a transformer tank.

The container 60 comprises an enclosing structure, which has an inner surface at least in part delimiting an interior space 70 of the container 60, in which interior space 70 the transformer 20 is arranged (or arrangeable). The enclosing structure has an electrical feedthrough arrangement, schematically indicated at 80 in Figure 1, which feedthrough arrangement 80 is comprised in a portion of the enclosing structure. The electrical feedthrough arrangement 80 comprises at least one first electrically conducting path, schematically indicated at 81 in Figure 1, configured to conduct current in a direction from the electrical pulse generating unit 10 to the transformer 20, and at least one second electrically conducting path, schematically indicated at 82 in Figure 1, configured to conduct current in a direction from the transformer 20 to the electrical pulse generating unit 10. At least a portion of the said portion of the enclosing structure is electrically conductive. Each first electrically conducting path 81 may have a corresponding second electrically conducting path 82. Each first electrically conducting path 81 and the corresponding second electrically conducting path 82 may be configured to form a part of a corresponding closed electrical circuit between the electrical pulse generating unit 10 and the transformer 20. As will be further described in the following with reference to other figures, each first electrically conducting path 81 is at least in part formed by at least one electrical conductor surrounded by an electrically insulating body fitted within a corresponding through-hole in the said portion of the enclosing structure extending between an outer surface of the enclosing structure and the inner surface of the enclosing structure. And as also will be further described in the following with reference to other figures, each second electrically conducting path 82 is at least in part formed by an electrically conductive portion of the said portion of the enclosing structure.

As indicated in Figure 1, the load 90 may be arranged outside the container 60. However, in accordance with one or more embodiments of the present invention, the load 90 could be arranged at least in part inside the (interior space 70 of the) container 60.

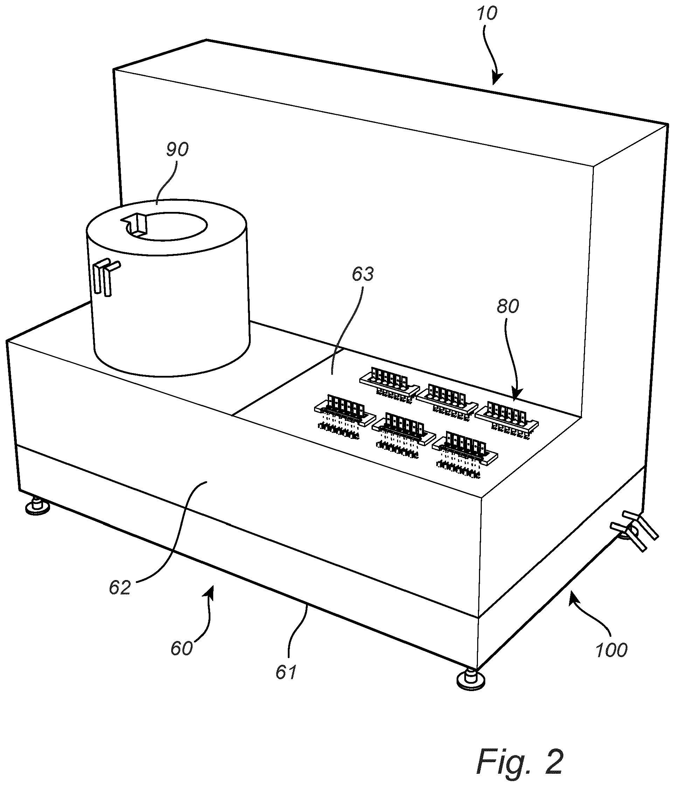

Figure 2 is a schematic perspective view of an electrical pulse generating apparatus 100 according to one or more embodiments of the present invention, which electrical pulse generating apparatus 100 is connected to a load 90. The electrical pulse generating apparatus 100 comprises an electrical pulse generating unit 10, which is configured to generate one or more electrical pulses to be conveyed to the load 90. While Figure 2 does not illustrate any of the constituent components of the electrical pulse generating unit 10 and generally only illustrates a housing of the electrical pulse generating unit 10, it is to be understood that the electrical pulse generating unit 10 may be configured for example in accordance with the electrical pulse generating unit 10 as described in the foregoing with reference to Figure 1. The electrical pulse generating apparatus 100 comprises an electrical device (not visible in Figure 2) which is constituted by a transformer and is connected or connectable to the electrical pulse generating unit 10 and arranged such that any electrical pulse generated by the electrical pulse generating unit 10 is conveyed to the load 90 via the transformer. The electrical pulse generating apparatus 100 comprises a container 60 according to one or more embodiments of the present invention, which container 60 is configured to accommodate the transformer. The container 60 may be generally configured for example in accordance with the container 60 as described in the foregoing with reference to Figure 1. For example, as described with reference to Figure 1, the container 60 may comprise an enclosing structure, which may have an inner surface at least in part delimiting an interior space 70 of the container 60, in which interior space 70 the electrical device may be arranged or arrangeable. The inner surface of the enclosing structure is schematically indicated by reference numeral 64 in Figure 1.

With further reference to the embodiment of the present invention illustrated in Figure 2, the transformer is arranged in the interior space of the container 60. Further, the container 60 comprises an enclosing structure 61, which in accordance with the embodiment of the present invention illustrated in Figure 2 is generally formed having a rectangular cuboid shape, or in the shape of a box, and has several walls, one of which is indicated at 62, an opening and a closure device 63. The closure device 63 is connected to the walls and may be configured to selectively close or open the opening. In accordance with the embodiment of the present invention illustrated in Figure 2, the closure device 63 comprises a lid or cover. Figure 2 illustrates a state in which the closure device 63 is in a position operable to close the opening. Further in accordance with the embodiment of the present invention illustrated in Figure 2, the enclosing structure 61 may have a bottom part (not shown in Figure 2). The interior space of the container 60 is delimited at least in part by an inner surface of the walls of the enclosing structure 61 (and possibly by an inner surface of any bottom part).

The enclosing structure 61 may have several electrical feedthrough arrangements, one of which is indicated at 80 in Figure 2, wherein each of the electrical feedthrough arrangements may be comprised in a portion of the enclosing structure 61. As illustrated in Figure 2, the electrical feedthrough arrangements are arranged at a distance in relation to each other. In accordance with the embodiment of the present invention illustrated in Figure 2, there are two rows of electrical feedthrough arrangements, with the rows of electrical feedthrough arrangements being arranged (e.g., substantially) in parallel with each other, and with each row of electrical feedthrough arrangements including three spaced-apart electrical feedthrough arrangements. However, it is to be understood that such configuration of the electrical feedthrough arrangements is exemplifying and that variations are possible. For example, the electrical feedthrough arrangements do not necessarily have to be arranged in rows, each row of electrical feedthrough arrangements may include fewer or more than three electrical feedthrough arrangements, and different rows of electrical feedthrough arrangements do not necessarily have to be arranged (e.g., substantially) in parallel with each other. Further, the total number of electrical feedthrough arrangements illustrated in Figure 2 is exemplifying, and it is to be understood that the enclosing structure 61 may have fewer or more electrical feedthrough arrangements than what is illustrated in Figure 2. According to one particular example, the enclosing structure 61 could have a single electrical feedthrough arrangement.

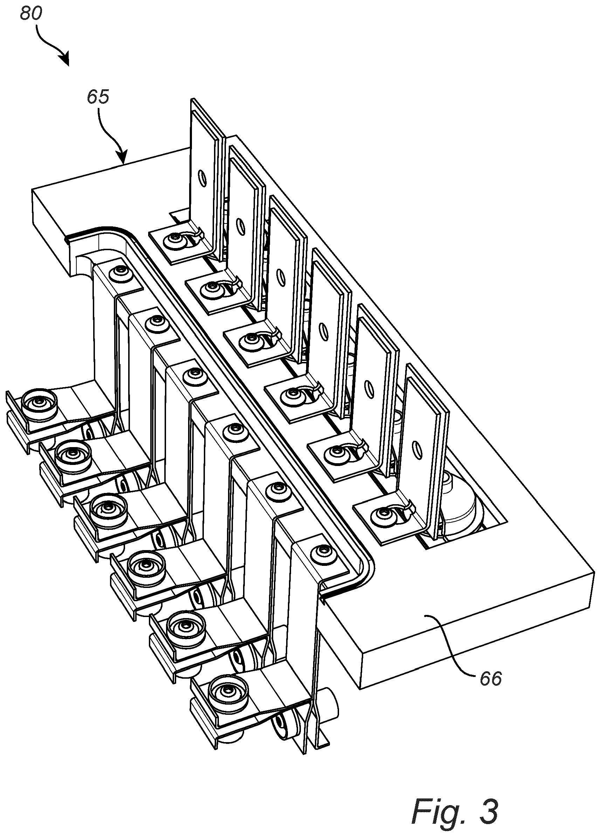

In accordance with the embodiment of the present invention illustrated in Figure 2, the said portion of the enclosing structure 61 in which the electrical feedthrough arrangement 80 is comprised may comprise a portion of the closure device 63. The electrical feedthrough arrangement 80 according to one or more embodiments of the present invention is illustrated in further detail in Figures 3 to 7 and will be described in further detail in the following with reference to those figures.

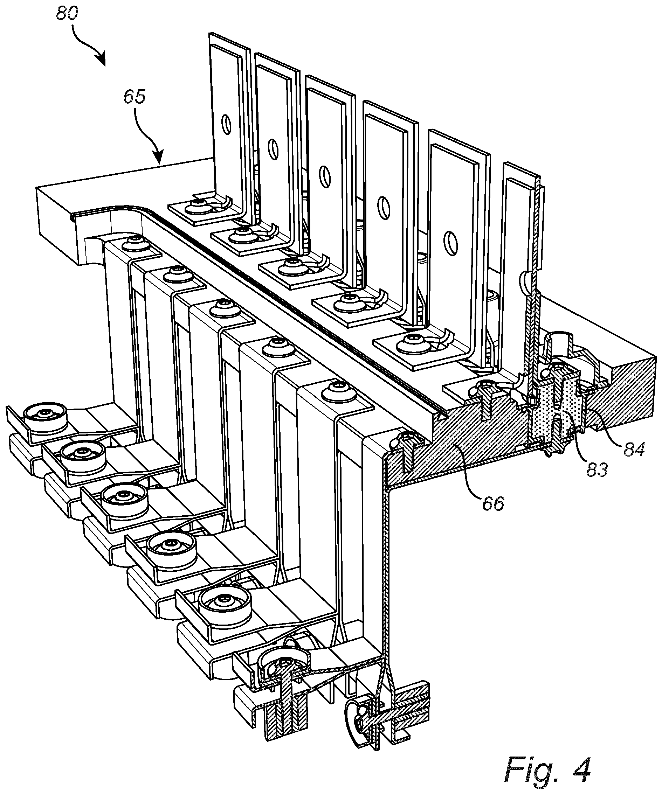

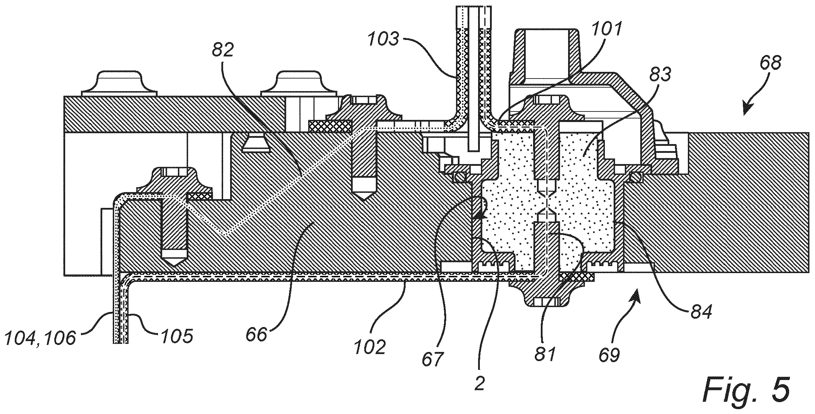

Figure 3 is a schematic perspective view of a portion 65 of the enclosing structure of a container according to one or more embodiments of the present invention, in which portion 65 an electrical feedthrough arrangement 80 according to one or more embodiments of the present invention is comprised in. Figure 4 is an in-part sectional view of the portion 65 of the enclosing structure illustrated in Figure 3. Figure 5 is a more detailed view of the section of the portion of the enclosing structure illustrated in Figure 4.

In accordance with the embodiments of the present invention illustrated in Figures 3 to 5, each electrical feedthrough arrangement 80 comprises a plurality of first electrically conducting paths and a plurality of second electrically conducting paths, wherein each first electrically conducting path is configured to conduct current in a direction from the electrical pulse generating unit to the transformer and each second electrically conducting path is configured to conduct current in a direction from the transformer to the electrical pulse generating unit. Each first electrically conducting path may have a corresponding second electrically conducting path, such that the electrical feedthrough arrangement 80 comprises a plurality of pairs of a first electrically conducting path and a corresponding second electrically conducting path. As indicated in Figures 3 and 4 in view of Figure 5, the said pairs may be arranged at a distance from each other.

One of the pairs of a first electrically conducting path and a corresponding second electrically conducting path is illustrated in Figure 4, which as mentioned is an in-part sectional view of the portion 65 of the enclosing structure illustrated in Figure 3, and in Figure 5, which as mentioned is a more detailed view of the section of the portion of the enclosing structure illustrated in Figure 4. This one of the pairs of a first electrically conducting path and a corresponding second electrically conducting path will be described further in the following with reference to Figures 4 and 5. It is to be understood that the other ones of the pairs of a first electrically conducting path and a corresponding second electrically conducting path may be configured in the same way or in a similar way.

With reference to Figures 4 and 5, the electrical feedthrough arrangement 80 comprises a first electrically conducting path 81, which is configured to conduct current in a direction from the electrical pulse generating unit to the transformer (and/or another type of electrical device), and a second electrically conducting path 82, which is configured to conduct current in a direction from the transformer to the electrical pulse generating unit. The first electrically conducting path 81 and the second electrically conducting path 82 are schematically indicated in Figure 5 by the dashed and dotted lines indicated by the reference numerals 81 and 82, respectively. At least a portion 66 of the said portion 65 of the enclosing structure is electrically conductive. The first electrically conducting path 81 and the corresponding second electrically conducting path 82 may be configured to form a part of a corresponding closed electrical circuit between the electrical pulse generating unit and the transformer.

The first electrically conducting path 81 is in part formed by an electrical conductor 83 that is surrounded by an electrically insulating body 84 fitted within a corresponding through-hole 67 in the said portion 65 of the enclosing structure, with the through-hole 67 extending between an outer surface 68 of the enclosing structure and an inner surface 69 of the enclosing structure. The electrically insulating body 84 and the said portion 65 of the enclosing structure may be arranged such that the electrically insulating body 84 is threadingly connected to a surface 2 of the said portion 65 of the enclosing structure which defines the through-hole 67 in the said portion 65 of the enclosing structure.

The second electrically conducting path 82 is in part formed by an electrically conductive portion (e.g., the portion 66) of the said portion 65 of the enclosing structure. In accordance with the one or more embodiments of the present invention illustrated in Figures 2 to 5, the portion 66 of the said portion 65 of the enclosing structure is a portion of the closure device 63, which may be a lid over cover. With reference to the example of the container 60 being constituted or including a tank (e.g., a transformer tank), the second electrically conducting path 82 may hence be directed or extending through a portion of the lid or cover of the tank.

In accordance with the one or more embodiments of the present invention illustrated in Figures 2 to 5, the first electrically conducting path 81 is further formed by a first electrical contact 101, which may be fixedly attached to the electrical conductor 83 at a first end thereof arranged at an outer surface 68 of the said portion 65 of the enclosing structure. The first electrically conducting path 81 is further formed by a second electrical contact 102, which may be fixedly attached to the electrical conductor 83 at a second end thereof arranged at an inner surface 69 of the said portion 65 of the enclosing structure. The first electrical contact 101 and the second electrical contact 102 may be coupled via the electrical conductor 83 and possibly also via other components, such as screws which have been screwed into the said portion 65 of the enclosing structure as perhaps best illustrated in Figure 5. As perhaps best illustrated in Figures 3 to 5, the first electrical contact 101 and the second electrical contact 102 may be embodied as elongated strips of an electrically conductive material (e.g., comprising one or more metals) having been bent in one or more places along the strips.

Further in accordance with the one or more embodiments of the present invention illustrated in Figures 2 to 5, the second electrically conducting path 82 is further formed by a first electrical contact 103, which may be fixedly attached to an outer surface of the electrically conductive portion (e.g., the portion 66) of the said portion 65 of the enclosing structure. The second electrically conducting path 82 is further formed by a second electrical contact 104, which may be fixedly attached to an inner surface of the electrically conductive portion (e.g., the portion 66) of the said portion 65 of the enclosing structure. The first electrical contact 103 and the second electrical contact 104 may be coupled via the electrically conductive portion e.g., the portion 66) of the said portion 65 of the enclosing structure and possibly also via other components, such as screws which have been screwed into the said portion 65 of the enclosing structure as perhaps best illustrated in Figure 5. As perhaps best illustrated in Figures 3 to 5, the first electrical contact 103 and the second electrical contact 104 may be embodied as elongated strips of an electrically conductive material (e.g., comprising one or more metals) having been bent in one or more places along the strips.

It is to be understood that only a portion of the respective ones of the first electrical contact 101 of the first electrically conducting path 81 and the first electrical contact 103 of the second electrically conducting path 82 may be shown in Figure 5.

As perhaps best illustrated in Figure 5, there may be an electrical insulator positioned between the first electrical contact 101 of the first electrically conducting path 81 and the first electrical contact 103 of the second electrically conducting path 82. The electrical insulator which may be positioned between the first electrical contact 101 of the first electrically conducting path 81 and the first electrical contact 103 of the second electrically conducting path 82 may electrically insulate the first electrical contact 101 from the first electrical contact 103, and may for example comprise a layer or film of electrically insulating material, such as, for example, a Kapton film. Only a portion of the electrical insulator may be shown in Figure 5.

With further reference to Figure 2, for each or any first electrically conducting path 81 and for each or any second electrically conducting path 82, there may be provided one or more electrical conductors such as electrical cables (not shown in Figure 2) which may extend between the respective electrical feedthrough arrangement 80 and the electrical pulse generating unit 10. Such one or more electrical conductors may be considered as forming part of the respective ones of the first electrically conducting path(s) 81 and the second electrically conducting path(s) 82. For example, with reference to Figure 5, such one or more electrical conductors may be connected to respective ones of the first electrical contact 101 of the first electrically conducting path 81 and the first electrical contact 103 of the second electrically conducting path 82.

Further in accordance with the one or more embodiments of the present invention illustrated in Figures 2 to 5, each of the first electrically conducting path 81 and the corresponding second electrically conducting path 82 comprises an elongated electrical conductor 105 and 106, respectively, which extends into the interior space and towards the transformer when it is arranged in the interior space. In accordance with the one or more embodiments of the present invention illustrated in Figures 2 to 5, the elongated electrical conductors 105 and 106 are realized at least in part by parts or portions of the second electrical contact 102 of the first electrically conducting path 81 and the second electrical contact 104 of the second electrically conducting path 82, respectively. At least a portion of the electrical conductors 105 and 106 of the first electrically conducting path 81 and the corresponding second electrically conducting path 82, respectively, which are extending into the interior space may extend parallel to each other and at a distance from each other that may be in a range between 0.1 mm and 1 mm.

It is to be understood that the extension of the second electrically conducting path, which is schematically indicated in Figure 5 by the dotted line indicated by the reference numeral 82, through the said portion 65 of the enclosing structure as illustrated in Figure 5 is exemplifying, and that the second electrically conducting path 82 could be directed or extending in different ways through the said portion 65 of the enclosing structure, e.g., depending on which portion(s) of the said portion 65 of the enclosing structure that is or are electrically conductive. Such other ways of how the second electrically conducting path 82 could be directed or extending in different ways through the said portion 65 of the enclosing structure while being at least in part formed by an electrically conductive portion of the said portion 65 of the enclosing structure are contemplated and are within the scope of the present disclosure.

It is to be understood that while Figures 2-4 show the electrical conductors 105 and 106 and the second electrical contact 104 of each of the pairs of a first electrically conducting path and a corresponding second electrically conducting path of the illustrated electrical feedthrough arrangement(s) 80, the electrical conductors 105 and 106 and the second electrical contact 104 may in use of the electrical pulse generating apparatus 100 (e.g., in an assembled state of the electrical pulse generating apparatus 100) be covered and obscured from view by a user, e.g., by a portion of the enclosing structure, such as a portion of a lid or cover of the enclosing structure, as indicated in Figure 5.

With further reference to Figure 5, it is to be understood that only a portion of the respective ones of the second electrical contact 104 and the electrical conductors 105 and 106 may be shown in Figure 5.

While not illustrated in Figure 5, there may be an electrical insulator positioned between the electrical contact 102 of the first electrically conducting path 81 and the inner surface 69 of the enclosing structure, such as between the inner surface of the portion 66 of the said portion 65 of the enclosing structure. The electrical insulator which may be positioned between the inner surface 69 of the enclosing structure may electrically insulate the electrical contact 102 of the first electrically conducting path 81 from the enclosing structure (e.g., from the portion 66 of the said portion 65 of the enclosing structure), and may for example comprise a layer or film of electrically insulating material, such as, for example, a Kapton film.

Further, while not illustrated in Figure 5, there may be an electrical insulator positioned between the elongated electrical conductors 105 and 106 or between the second electrical contact 104 of the second electrically conducting path 82 and the elongated electrical conductor 105, for electrically insulating the elongated electrical conductor 105 from the elongated electrical conductor 106 or the second electrical contact 104 of the second electrically conducting path 82 from the elongated electrical conductor 105. Such electrical insulator may for example comprise a layer or film of electrically insulating material, such as, for example, a Kapton film.

With further reference to Figure 2, in accordance with the one or more illustrated embodiment of the present invention, the load 90 is arranged in part inside the (interior space of the) container 60. However, this is not required. For example, as indicated in Figure 1, the load 90 may be arranged (e.g., completely) outside the container 60. Further in accordance with the embodiment of the present invention illustrated in Figure 2, the load 90 comprises a klystron, a part of which is visible in Figure 2. In alternative or in addition, the load 90 could comprise or be constituted for example by a microwave amplifier, a magnetron, and/or a particle emitter.

Further in accordance with the embodiment of the present invention illustrated in Figure 2, the illustrated klystron may be in part extending through a through-hole of the enclosing structure 61 of the container 60. The part of the klystron which is within the interior space may be connected to the transformer for example by means of a so-called klystron socket arranged within the interior space and with which the klystron may be coupled. Such a klystron socket may include a plurality of metallic rods. Three of the metallic rods may be connected to the klystron cathode, e.g., by means of a brush charged by spring contacts. One of the metallic rods may be connected to the klystron filament. Each or any of such rods may be spring-loaded, which may facilitate connection of the rod(s) to klystron even if the surface to which the rod(s) is or are to be connected would be uneven. Further, for each or any of such rods, the end thereof to be connected to the klystron may be provided with metal cushions, which may (e.g., further) facilitate connection of the rod(s) to klystron. However, other types of connections of the load to the transformer (and/or another electrical device) are possible. For example, the load may be in part extending through a through-hole of the enclosing structure 61 of the container 60, similar to the klystron illustrated in Figure 2, and the part of the load which is within the interior space may be connected to the transformer by means of one or more electrical cables or other types of conductors.

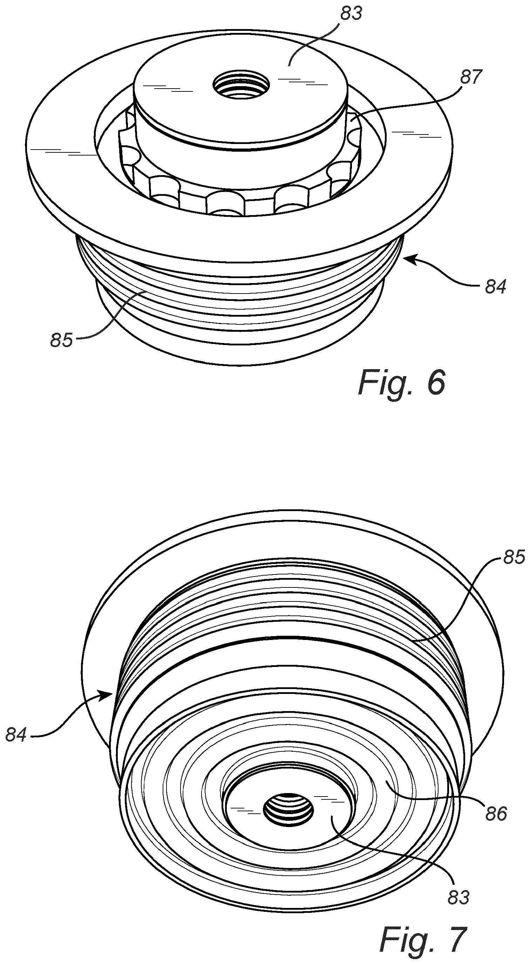

Each of Figures 6 and 7 is a schematic view of a part of a first electrically conducting path of an electrical feedthrough arrangement of a container according to one or more embodiments of the present invention. The illustrated part of the first electrically conducting path includes an electrical conductor 83 that is surrounded by an electrically insulating body 84. As illustrated in Figures 6 and 7, the electrically insulating body 84 may have a (e.g., generally) cylindrical shape with an interior space (e.g., being defined by a through-hole in the electrically insulating body 84, which through-hole may extend along a longitudinal direction of the electrically insulating body 84) into which the electrical conductor 83 may be fitted (e.g., interference fitted or press fitted). As described in the foregoing with reference to Figures 4 and 5 and illustrated in those figures, the electrically insulating body 84 may be fitted within a corresponding through-hole 67 in the said portion 65 of the enclosing structure, and the electrically insulating body 84 and the said portion 65 of the enclosing structure may be arranged such that the electrically insulating body 84 is threadingly connected to a surface 2 of the said portion 65 of the enclosing structure which defines the through-hole 67 in the said portion 65 of the enclosing structure. To that end, and in accordance with the embodiments of the present invention illustrated in Figures 6 and 7, the electrically insulating body 84 may be or generally be configured as a screw, and may have outer threads 85 facilitating or allowing for the electrically insulating body 84 to be fitted within the corresponding through-hole 67 in the said portion 65 of the enclosing structure. The outer threads 85 may match with grooves or threads on the surface 2 such that the electrically insulating body 84 may be screwed into the said portion 65 of the enclosing structure. In order to facilitate screwing the electrically insulating body 84 into the said portion 65 of the enclosing structure, the electrically insulating body 84 may be provided with grooves 87 at a first end of the electrically insulating body 84 (e.g., an upper end of the electrically insulating body 84). The grooves 87 may facilitate screwing the electrically insulating body 84 into the said portion 65 of the enclosing structure using a socket wrench. Further, by appropriate design of the shape of the grooves 87, it may be facilitated or allowed to achieve a sufficient electrical creepage distance for complying with electrical safety requirements. As illustrated in Figure 7, the electrically insulating body 84 may be provided with an undulating surface pattern 86 at a second end of the electrically insulating body 84 (e.g., a lower end of the electrically insulating body 84). As illustrated in Figure 7, the second end of the electrically insulating body 84 may be opposite to the first end of the electrically insulating body 84. By such an undulating surface pattern 86, it may be (e.g., further) facilitated or allowed to achieve a sufficient electrical creepage distance for complying with electrical safety requirements. A configuration of the electrical conductor 83 and the electrically insulating body 84 such as has been described in the foregoing with reference to Figures 6 and 7 may be applied to each or any of the herein disclosed embodiments of the first electrically conducting path.

In conclusion, a container is disclosed. The container is configured to accommodate an electrical device connected or connectable to an electrical pulse generating unit, with the electrical pulse generating unit being configured to generate one or more electrical pulses to be conveyed to the electrical device. The container comprises an enclosing structure having an inner surface at least in part delimiting an interior space of the container, in which interior space the electrical device is arranged or arrangeable. The enclosing structure has an electrical feedthrough arrangement comprised in a portion of the enclosing structure.

While the present invention has been illustrated in the appended drawings and the foregoing description, such illustration is to be considered illustrative or exemplifying and not restrictive; the present invention is not limited to the disclosed embodiments. Other variations to the disclosed embodiments can be understood and effected by those skilled in the art in practicing the claimed invention, from a study of the drawings, the disclosure, and the appended claims. In the appended claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A container (60) configured to accommodate an electrical device (20) connected or connectable to an electrical pulse generating unit (10), the electrical pulse generating unit being configured to generate one or more electrical pulses to be conveyed to the electrical device, the container comprising:
an enclosing structure (61) having an inner surface (64) at least in part delimiting an interior space (70) of the container, in which interior space the electrical device is arranged or arrangeable;
wherein the enclosing structure has an electrical feedthrough arrangement (80) comprised in a portion (65) of the enclosing structure, wherein the electrical feedthrough arrangement comprises at least one first electrically conducting path (81) configured to conduct current in a direction from the electrical pulse generating unit to the electrical device, and at least one second electrically conducting path (82) configured to conduct current in a direction from the electrical device to the electrical pulse generating unit, wherein at least a portion (66) of the said portion of the enclosing structure is electrically conductive;
wherein each first electrically conducting path has a corresponding second electrically conducting path, and each first electrically conducting path and the corresponding second electrically conducting path are configured to form a part of a corresponding closed electrical circuit between the electrical pulse generating unit and the electrical device;
wherein each first electrically conducting path is at least in part formed by at least one electrical conductor (83) surrounded by an electrically insulating body (84) fitted within a corresponding through-hole (67) in the said portion of the enclosing structure extending between an outer surface (68) of the enclosing structure and the inner surface (69) of the enclosing structure, and each second electrically conducting path is at least in part formed by an electrically conductive portion of the said portion of the enclosing structure.

2. A container according to claim 1, wherein the enclosing structure comprises:
at least one wall (62);
at least one opening; and
at least one closure device (63) connected to the at least one wall or formed by a portion of the at least one wall, the at least one closure device being configured to selectively close or open the at least one opening, wherein the interior space is delimited at least in part by an inner surface of the at least one wall;
wherein the said portion of the enclosing structure comprises a portion of the at least one wall and/or the at least one closure device.

3. A container according to claim 2, wherein the at least one closure device comprises a lid or cover, and wherein the said portion of the enclosing structure comprises a portion of the lid or cover.

4. A container according to any one of claims 1-3, wherein the enclosing structure is configured to seal the interior space from the surroundings of the container.

5. A container according to any one of claims 1-4, wherein each first electrically conducting path is further formed by a first electrical contact (101), which is fixedly attached to the at least one electrical conductor at a first end thereof arranged at an outer surface of the said portion of the enclosing structure, and a second electrical contact (102), which is fixedly attached to the at least one electrical conductor at a second end thereof arranged at an inner surface of the said portion of the enclosing structure, wherein the first electrical contact and the second electrical contact are coupled via the at least one electrical conductor.

6. A container according to any one of claims 1-5, wherein each second electrically conducting path is further formed by a first electrical contact (103), which is fixedly attached to an outer surface of the electrically conductive portion of the said portion of the enclosing structure, and a second electrical contact (104), which is fixedly attached to an inner surface of the electrically conductive portion of the said portion of the enclosing structure, wherein the first electrical contact and the second electrical contact are coupled via the electrically conductive portion of the said portion of the enclosing structure.

7. A container according to any one of claims 1-6, wherein for each first electrically conducting path, the electrically insulating body and/or the said portion of the enclosing structure are arranged such that the electrically insulating body is sealingly fitted within the corresponding through-hole in the said portion of the enclosing structure.

8. A container according to any one of claims 1-7, wherein for each first electrically conducting path, the electrically insulating body and the said portion of the enclosing structure are arranged such that the electrically insulating body is threadingly connected to a surface (2) of the said portion of the enclosing structure which defines the corresponding through-hole in the said portion of the enclosing structure.

9. A container according to any one of claims 1-8, wherein the at least one first electrically conducting path is configured to convey the one or more electrical pulses generated by the electrical pulse generating unit to the electrical device, and the at least one second electrically conducting path constitutes a current return path from the electrical device and is connected to ground.

10. A container according to any one of claims 1-9, wherein the container is configured to accommodate a transformer, wherein the electrical device comprises or is constituted by the transformer.

11. A container according to any one of claims 1-10, for each first electrically conducting path, the electrically insulating body comprises a through-hole extending between an outer surface of the said portion of the enclosing structure and an inner surface of the said portion of the enclosing structure, and wherein the at least one electrical conductor is fitted within the through-hole of the electrically insulating body.

12. A container according to claim 11, wherein at least one of the following applies:
the electrically insulating body and/or the at least one electrical conductor are arranged such that the at least one electrical conductor is sealingly fitted within the through-hole of the electrically insulating body;
the electrically insulating body and the at least one electrical conductor are arranged such that the at least one electrical conductor is threadingly connected to a surface of the electrically insulating body which defines the through-hole of the electrically insulating body.

13. A container according to any one of claims 1-12, wherein for each first electrically conducting path and the corresponding second electrically conducting path, each of the first electrically conducting path and the corresponding second electrically conducting path comprises an elongated electrical conductor (105, 106) extending into the interior space and towards the electrical device when it is arranged in the interior space, wherein at least a portion of the electrical conductors of the first electrically conducting path and the corresponding second electrically conducting path extending into the interior space extend parallel to each other and at a distance from each other that is in a range between 0.1 mm and 1 mm.

14. An electrical pulse generating apparatus (100) connected or connectable to a load, the electrical pulse generating apparatus comprising:
an electrical pulse generating unit (10) configured to generate one or more electrical pulses to be conveyed to the load;
an electrical device (20) constituted by a transformer connected or connectable to the electrical pulse generating unit and arranged such that any electrical pulse generated by the electrical pulse generating unit is conveyed to the load via the transformer; and
a container (60) according to any of claims 1-13 configured to accommodate the transformer, wherein the transformer is arranged in the interior space (70) of the container.
